# EUROPÄISCHE PATENTSCHRIFT

(11) **EP 0 479 316 B1**
(45) Veröffentlichungstag und Bekanntmachung des Hinweises auf die Patenterteilung: **15.01.1997**
(21) Anmeldenummer: 91116989.4
(22) Anmeldetag: 04.10.1991
(51) Int. Cl.: H05K 7/02, H05K 7/18

(54) **Geräte- und Kabeltrageeinrichtung**
Supporting structure for cables and apparatus
Dispositif porteur pour des câbles et des appareils

(30) Priorität: 04.10.1990 DE 9013824 U
(43) Veröffentlichungstag der Anmeldung: 08.04.1992
(73) Patentinhaber: Moll, Hans, D-88069 Tettnang (DE)
(72) Erfinder: Moll, Hans, D-88069 Tettnang (DE)
(74) Vertreter: Neidl-Stippler, Cornelia, Dr.

(56) Entgegenhaltungen:
- EP-A- 0 057 580
- DE-A- 2 716 859
- DE-A- 3 706 797
- DE-U- 8 717 181

## Beschreibung

Die Erfindung betrifft eine Geräte- und Kabeltrageeinrichtung; siehe z. B. EP-A-0 057 580.

Kabelschränke bzw. Verteilerschränke, die zur Aufnahme der sehr zahlreichen Kabel, wie sie beispielsweise in Computerräumen oder dergleichen auftreten, geeignet sind, sind bereits bekannt. Auf dem Markt werden sogenannte 19- Zoll-Schränke angeboten, die zur besseren Zugänglichkeit vorne und hinten eine Tür besitzen, wobei sich in diesen Schränken beispielsweise Koppler, Patchboxen, Baugruppenträger, Stromversorgungen, USV und dergleichen befinden, wie sie für Netzwerke benötigt werden.

Üblicherweise sind derartige Schränke abschließbar, um ein unbefugtes Entfernen bzw. Vertauschen von Einzelkomponenten zu vermeiden.

Die bisher verwendeten Verteilerschränke waren insofern nachteilig, als sie einen großen Platzbedarf hatten - die Vorder- und Rücktüre erforderte, daß der Schrank von der Wand relativ weit weg gerückt stehen mußte, um von hinten her Zugang zu den rückwärtigen Anschlüssen zu haben, und für die Vordertüre ebenfalls Platz frei gelassen werden mußte, um einen Zugang zum Schrankinneren bzw. eine Öffnung dieser Tür zu ermöglichen.

Ferner waren die bekannten Schränke insofern nachteilig, als sie zwar ermöglichten, Ordnung und Übersichtlichkeit in den bisher bekannten Kabelanordnungen zu halten, sie selbst aber unübersichtlich und schwer zugänglich waren. Von der Seite war es fast unmöglich, an der Seitenwand vorbei in das Schrankinnere zu gelangen und durch die Schrankdecke war auch das Beleuchtungsproblem nicht optimal gelöst innerhalb des Schrankes war stets eine schlechte Beleuchtung und damit schlechte Handhabung der im Schrank angeordneten Komponenten möglich. Bisher bekannte Schränke hatten auch den Nachteil, nicht erweiterbar zu sein, so daß bei Erweiterung der Computerarchitektur, die zu mehr Kabeln führte, ein neuer Schrank beschafft werden mußte. Die bisherigen Schränke hatten auch den Nachteil, daß sie stets in einem Stück angeliefert wurden, also ggf. Probleme mit dem Durchgang durch Türen, Transport über Treppen und auch mit dem Gewicht auftreten konnten. Somit waren die bisherigen Schränke, insbesondere auf einem Gebiet, auf dem ein reger und permanenter Umbau herrscht wie bei Datenübertragung, ungeeignet und unpraktikabel und führten zu erheblichen Zeitverlusten bei der Installation.

Diese Probleme werden erfindungsgemäß dadurch gelöst, daß nun eine Geräte- und Kabeltrageeinrichtung geschaffen wurde, die gekennzeichnet ist durch aneinander befestigbare End- und Zwischenelmente, wobei die Geräte- und Kabeltrageeinrichtung jeweils zwei Endelemente und dazwischen in beliebiger Menge anzuordnende Zwischenelemente aufweist, wobei
a) jedes Zwischenelement ein oberes und ein unteres Kabelkanalteil sowie ein senkrechtes Kabelführungsteil aufweist, das jeweils mittig mit dem oberen und unteren Kabelkanalteil verbindbar ist, und jeweils ein sich senkrecht vom unteren Kabelkanal- zum oberen Kabelkanalteil erstreckendes hohles Kabelzuführteil aufweist, wobei das Kabelzuführteil auf Öffnungen im unteren und oberen Kabelkanalteil gesetzt wird, so daß Durchleiten eines Kabels durch diese Kanalteile möglich ist;
b) jedes Endelement ein unteres Kabelkanalendteil und ein oberes Kabelkanalendteil sowie ein senkrecht auf den Enden der Kabelkanalendteile befestigbares Kabelführungsendteil aufweist, wobei das hohle Kabelführungsendteil auf Öffnungen der unteren und oberen Kabelkanalendteile gesetzt wird, so daß eine Durchleitung von elektrischen Leitungen durch dieselben möglich ist, sowie untere und obere, sich senkrecht von der durch die Kabelkanäle und den Kabelführungsteil erstreckende hohle rohrartige, vierkantrohrartige Kabelzuführteile aufweist und
c) horizontale und vertikale Rahmenteile, bevorzugt Doppelrahmenteile, die sich zwischen den oberen und unteren Kabelzuführteilen parallel zu den senkrechten Kabelführungsteilen erstrecken und Befestigungseinrichtungen, wie Bohrungen, aufweisen, vorgesehen sind.

Dadurch, daß nun eine offene Kabelordnungseinrichtung geschaffen wird, in der die Kabel übersichtlich angeordnet und von allen Seiten zugänglich befestigbar sind, ist es möglich, bei erheblich weniger Platzbedarf eine leichter zu handhabende Kabelordnungseinrichtung zu haben. Durch die optimale Erweiterbarkeit der Anordnung ist es ferner möglich, die Einrichtung in beliebiger Weise zu verlängern bzw. zu vergrößeren oder auch zu verkleinern, wodurch deren Einsetzbarkeit und Handhabbarkeit beträchtlich erhöht wird.

Ferner ist festzustellen, daß auch das geringe Gewicht und die leichte Transportierbarkeit im Gegensatz zu Schränken sehr viel weniger Aufwand erfordern. So ist es z.B. nicht notwendig, ein spezielles Transportunternehmen zur Förderung eines Verteilerschrankes anzufordern, sondern durch Auseinanderschrauben bzw. Auseinanderziehen der Einzelkomponenten entstehen modulartige Teile, die von jedem transportiert werden können. Dadurch, daß die Geräte- und Kabeltrageeinrichtung von allen Seiten offen ist, ist eine optimale Ausleuchtung leicht möglich und vereinfacht das Arbeiten stark.

Dadurch, daß die Kabelsteckverbindungen, die sich hier bevorzugt in den Abführungskanälen befinden, verschließbar sind, ist auch hier eine Sicherheit gegenüber ungewolltem Vertauschen von Anschlüssen und auch ein Schutz der Anschlüsse gegenüber Auseinanderziehen oder dergleichen möglich. Durch das Vorsehen der schnell aushängbaren Scharniere ist ebenfalls eine verbesserte Zugänglichkeit zu den Kabelverbindungen, die sich in den Kabelkanälen befinden, möglich, so daß auch hier eine erhebliche Vereinfachung der Handhabbarkeit des Schrankes und der Zugänglichkeit der darin befindlichen Kabel gegeben ist.

Vorteilhafterweise befinden sich zwischen den oberen und unteren Kabelzuführteilen sich senkrecht erstreckende Bleche mit Befestigungseinrichtungen, die sich an die vertikalen Rahmenteile anschließen.

Bevorzugt sind die Rahmenteile Doppelrahmen mit Bohrungen und die Bleche Lochbleche, wobei die Löcher Befestigungseinrichtungen sind.

Dabei sind bevorzugt die Abstände der einzelnen Befestigungseinrichtungen und der Abstand zwischen den Kabelkanälen so ausgewählt, daß sie der 19 Zoll-Ordnung (19-Zoll-Architektur der EDV-Technik) entsprechen.

Es kann günstig seind, wenn bei einer erfindungsgemäßen Geräte- und Kabeltrageeinrichtung die senkrechten Kabelführungsteile einzeln abschließbare Kabelkanäle mit abnehmbaren, ggf. verschließbaren Türen sind. Bevorzugt ist mindestens ein Kabelkanalteil auf der der Kabelzuführeinrichtung gegenüberliegenden Seite, der Frontseite, mit einer aushängbaren Tür, bevorzugt abschließbar, versehen, wobei bspw. mindestens einige der Türen schnell aushängbare Scharniere aufweisen können.

Bevorzugt ist also die erfindungsgemäße Geräte- und Kabeltrageeinrichtung so ausgelegt, daß sie in die sogenannte 19 Zoll-Technik paßt - es handelt sich hierbei um Geräte, die sich in Gehäusen befinden, deren Außenmaße alle 19 Zoll betragen - sie können also leicht aufeinander gestellt bzw. aufeinander angepaßt werden.

Durch die Lochreihen in den Doppelrahmenteilen ist es möglich, Fachböden in beliebiger Höhe und Menge anzubringen, so daß eine optimale Flexibilität der Geräte- und Kabeltrageeinrichtung zum Einbringen von Geräten wie beispielsweise Spannungskonstanthaltern oder Kopplern oder dergleichen möglich ist.

Auch die Lochbleche ermöglichen es, ggf. Halteeinrichtungen für sich von den Geräten erstreckenden Kabeln vorzusehen, bis diese in die Kabelkanäle eingeleitet werden können und dadurch ein erhöhtes Maß an Sicherheit für den Kabelverlauf zu gewährleisten.

Vorteilhafte Ausgestaltungen der Erfindung ergeben sich aus den Unteransprüchen.

Nachfolgend soll anhand der Zeichnung die Erfindung näher erläutert werden.

Dabei zeigt:
Figur 1 eine perspektivische Ansicht einer bevorzugten Ausführungsform einer erfindungsgemäßen Einrichtung;
Figur 2 eine schematische Darstellung der Frontansicht der Einrichtung gemäß Figur 1;
Figur 3 einen Schnitt durch den unteren Kabelkanal sowie die zugehörigen Kabelzuführteile;
Figur 4 einen Schnitt entlang der Ebene eines Kabelzuführteiles;
Figur 5 ein Detail der Türverbindung eines Kabelzuführteiles
   und
Figur 6 ein Detail einer bevorzugten Ausführungsform einer schnell aushängbaren Tür.

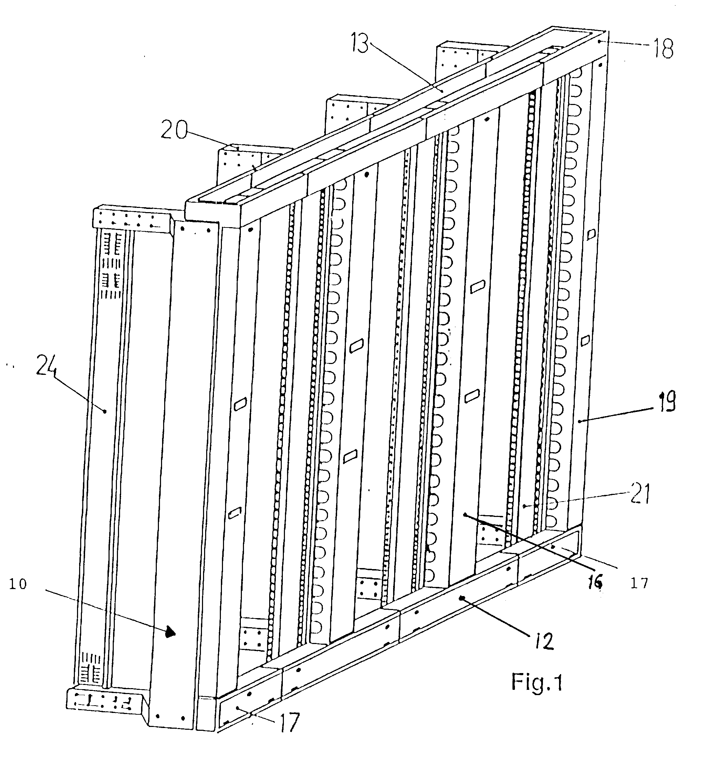

Wie in Figur 1 gezeigt, weist eine erfindungsgemäße Geräte-und Kabeltrageeinrichtung, wie sie hier aus zwei Zwischenelementen 121und zwei Endelementen 10 bestehend dargestellt ist, einen oberen Kabelkanal 13 und einen unteren Kabelkanal 14 auf, wobei diese jeweils durch ein oberes Kabelkanalendteil 18 und ein unteres Kabelkanalendteil 17 abgeschlossen werden, die Kabelführungsendteil 19 enden, wobei aber auch Verbindungen zwischen dem oberen und unteren Kabelkanal 13, 14 über Kabelführungsteile 16, die sich in regelmäßigen Abständen zwischen dem oberen und unteren Kabelkanal erstrecken, vorgesehen sind. Der Abstand dieser Kabelführungsteile entspricht hier der sogenannten 19-Zoll-Architektur; es können also zwischen zwei sich senkrecht erstreckende Kabelführungskanäle elektronische Geräte der 19-Zoll-Architektur eingebracht werden.

Hinter den Kabelführungskanälen befindet sich in dieser Ausführungsform ein Doppelrahmen aus horizontalen und vertikalen Rahmenteilen 21, 22, an dem zwischen den Kabelkanälen anzuordende Geräte mittels Schrauben, Steckverbindungen oder dergleichen befestigt werden können. Hinter den Rahmenteilen 21, 22 befinden sich bei dieser Ausführungsform Befestigungsbleche, hier als Lochbleche 24 ausgebildet, an denen weitere Befestigungen von herabhängenden Drähten und dergleichen möglich sind.

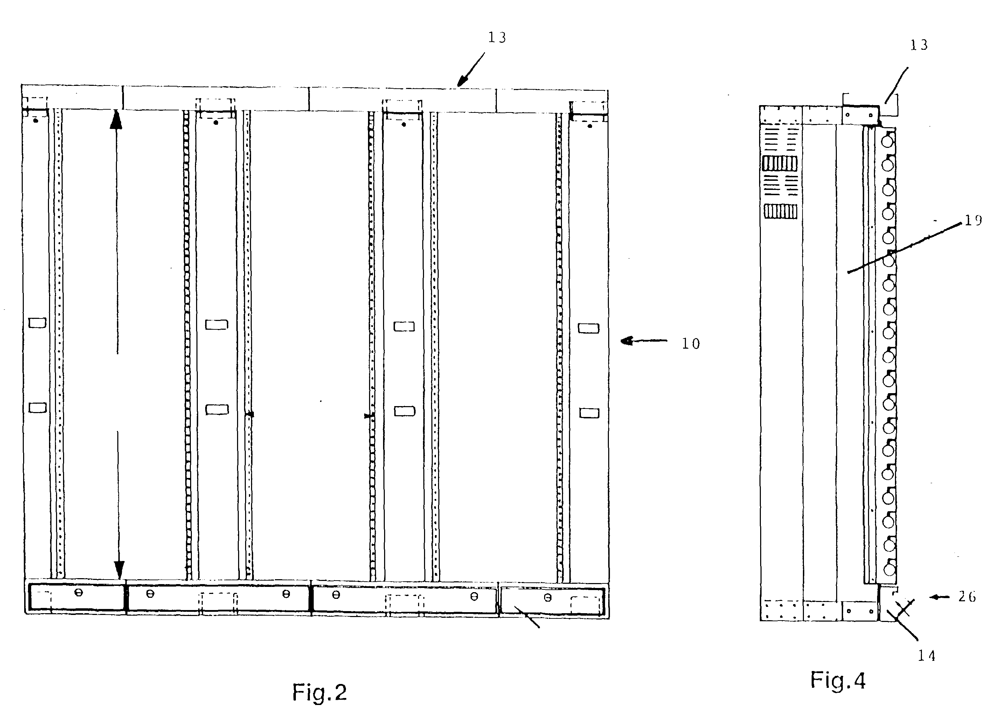

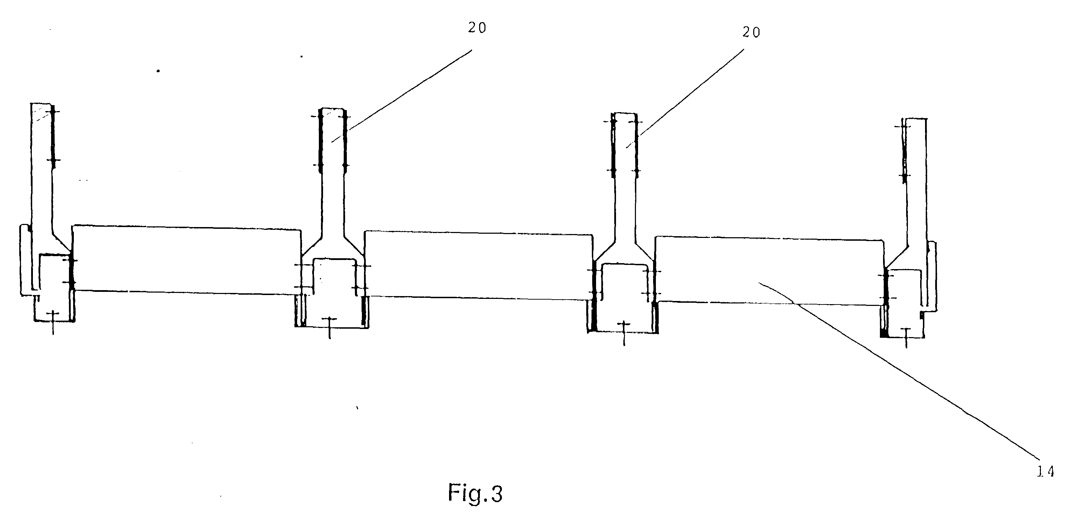

Eine Frontansicht der Anordnung ist in Figur 2 dargestellt.

Zu den Kabelkanälen führen Kabelzuführteile 20, die, wie insbesondere aus Figur 3 ersichtlich ist, hinten offen sind und eine Zuführung von Kabeln von hinten durch die Öffnungen im Kabelkanal ermöglichen.

Bei dieser Ausführungsform sind sie vierkantrohrartig ausgebildet.

Bei dieser Ausführungsform sind der untere Kabelkanal 17 sowie die Kabelführungsteile 16 abschließbar gestaltet, also die Frontwand des Kabelkanals ist durch eine verschließbare Türe 26 gebildet. Diese Tür 26 kann mittels herkömmlicher Schlösser und Verschließeinrichtungen - entweder mit Schlüsseln oder auch mit Codierungen - verschlossen werden und ist bevorzugt so gebaut, daß sie sogenannte schnell aushängbare Scharniere 27 besitzt, also vollständig nach Aufschließen der Tür vom Kanal getrennt werden kann, um ein optimales Arbeiten im Kanal ohne Behinderung durch eine vor diesem hängende Tür zu ermöglichen. Dabei ist vorgesehen, daß die aus den diversen Geräten zwischen den Kabelkanälen, aus denen bzw. über die verschiedene Kabel verlaufen, austretenden Kabel in die senkrechten Kabelführungsteile 16 durch darin ausgebildete Öffnungen eintreten, wobei diese Öffnungen bei Verschließen der Tür so gesichert sind, daß ein Herausziehen eines Kabelsteckers, der einen größeren Querschnitt als die Löcher hat, nicht mehr möglich ist.

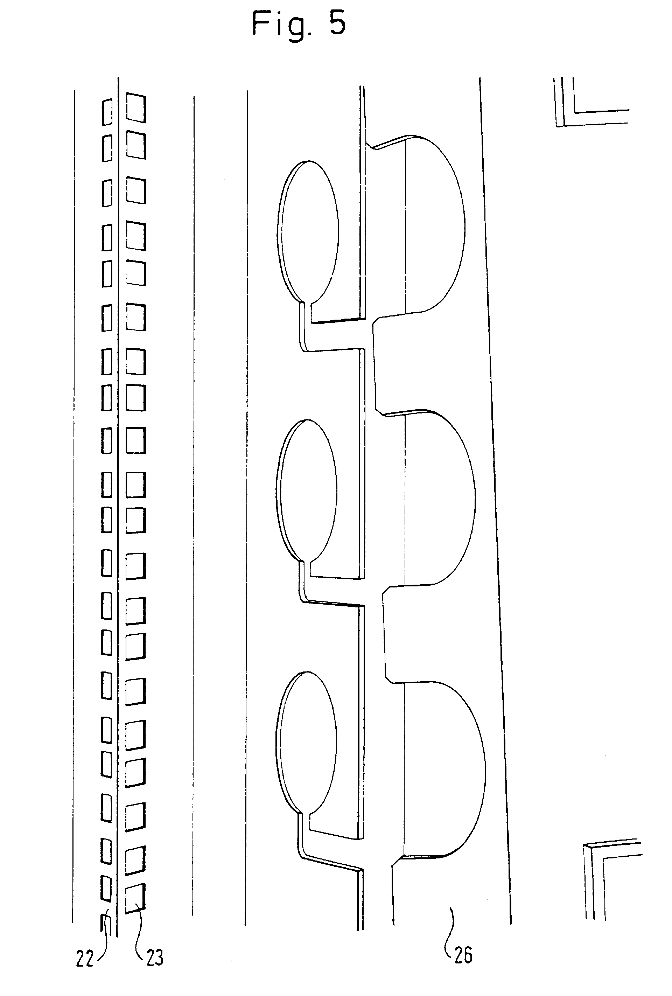

In Figur 5 ist ein Detail eines geöffneten Kabelführungsteils 16 gezeigt.

Eine derartige bevorzugte Ausgestaltung für einen derartigen Verschluß ist in Figur 4 gezeigt.

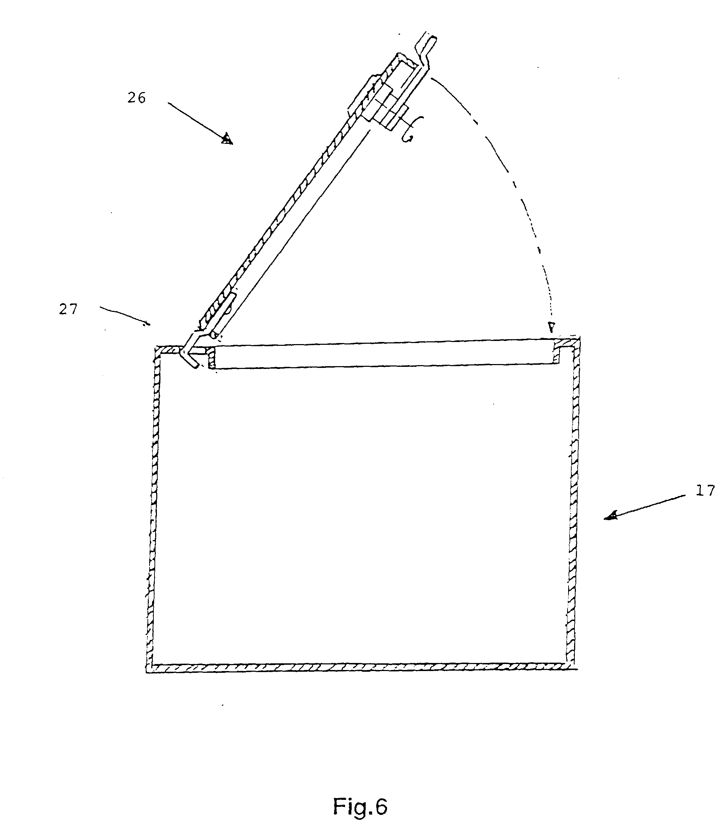

In Figur 6 ist ein schnell aushängbares Türscharnier 27, wie es hier bevorzugt eingesetzt wird, dargestellt, wobei ersichtlich ist, daß diese Scharniere ein völliges Abtrennen der Tür ohne großen technischen Aufwand vom Kabelkanal ermöglichen und auch schnell wieder eingesetzt werden können.

Dadurch, daß erstmals an Stelle eines geschlossenen, schwer zugänglichen Verteilerschrankes nun eine modulartige offene Bauweise für Geräte- und Kabeltrageeinrichtungen vorgesehen wird, ist eine beträchtliche Vereinfachung bei derartigen Vorrichtungen gegeben.

Bei der Erfindung handelt es sich somit um eine neuartige Geräte- und Kabeltrageeinrichtung, die zum Schutz der Kabelverbindungen dient, jedoch gegenüber den bisher verwendeten Verteilerschränken erheblich einfacher zu handhaben ist, im Gegensatz zu diesen erweiterbar ist und sich durch eine erheblich leichtere Bauweise und auch Transportierbarkeit auszeichnet.

### Bezugszeichenliste

- 10: Endelement
- 12: Zwischenelement
- 13: oberer Kabelkanal
- 14: unterer Kabelkanal
- 16: Kabelführungsteil
- 17: unteres Kabelkanalendteil von 10
- 18: oberes Kabelkanalendteil von 10
- 19: Kabelführungsendteil von 10
- 20: Kabelzuführteil
- 21: horizontales Rahmenteil
- 22: vertikales Rahmenteil
- 23: Befestigungseinrichtungen an 21 und 22
- 24: Blech, bevorzugt Lochblech
- 26: Tür
- 27: Scharnier, schnell abnehmbar

## Patentansprüche

1. Geräte- und Kabeltrageeinrichtung, gekennzeichnet durch aneinander befestigbare End- (10) und Zwischenelemente (12), wobei die Geräte- und Kabeltrageeinrichtung jeweils zwei Endelemente (10) und dazwischen in beliebiger Menge anzuordnende Zwischenelemente (12) aufweist, wobei
a) jedes Zwischenelement (12) ein oberes (13) und ein unteres Kabelkanalteil (14) sowie ein senkrechtes Kabelführungsteil (16) aufweist, das jeweils mittig mit dem oberen (13) und unteren (14) Kabelkanalteil verbindbar ist, und jeweils ein sich senkrecht vom unteren Kabelkanal- zum oberen Kabelkanalteil erstreckendes hohles Kabelzuführteil (20) aufweist, wobei das Kabelzuführteil (20) auf Öffnungen im unteren und oberen Kabelkanalteil gesetzt wird, so daß Durchleiten eines Kabels durch diese Kanalteile möglich ist;
b) jedes Endelement (10) ein unteres Kabelkanalendteil (17) und ein oberes Kabelkanalendteil (18) sowie ein senkrecht auf den Enden der Kabelkanalendteile befestigbares Kabelführungsendteil (19) aufweist, wobei das hohle Kabelführungsendteil (19) auf Öffnungen der unteren und oberen Kabelkanalendteile (17, 18) gesetzt wird, so daß eine Durchleitung von elektrischen Leitungen durch dieselben möglich ist, sowie untere und obere, sich senkrecht von der durch die Kabelkanäle und den Kabelführungsteil erstreckende hohle rohrartige, bevorzugt vierkantrohrartige Kabelzuführteile (20) aufweist und
c) horizontale (21) und vertikale (22) Rahmenteile, bevorzugt Doppelrahmenteile, die sich zwischen den oberen und unteren Kabelzuführteilen (20) parallel zu den senkrechten Kabelführungsteilen erstrecken und Befestigungseinrichtungen, wie Bohrungen, aufweisen, vorgesehen sind.

2. Geräte- und Kabeltrageeinrichtung gemäß Anspruch 1, dadurch gekennzeichnet, daß zusätzlich zwischen den oberen und unteren Kabelzuführteilen (20) sich senkrecht erstreckende Bleche (24) mit Befestigungseinrichtungen vorgesehen sind, die sich an die vertikalen Rahmenteile anschließen.

3. Geräte- und Kabeltrageeinrichtung nach Anspruch 1, dadurch gekennzeichnet, daß die Rahmenteile (21, 22) Doppelrahmen mit Bohrungen sind.

4. Geräte- und Kabeltrageeinrichtung nach Anspruch 2, dadurch gekennzeichnet, daß die Bleche (24) Lochbleche sind, wobei die Löcher Befestigungseinrichtungen sind.

5. Geräte- und Kabeltrageeinrichtung nach einem der vorangehenden Ansprüche, dadurch gekennzeichnet, daß die Abstände der einzelnen Befestigungseinrichtungen und der Abstand zwischen den Kabelkanälen so ausgewählt ist, daß sie der 19 Zoll-Ordnung (19-Zoll-Architektur der EDV-Technik) entsprechen.

6. Geräte- und Kabeltrageeinrichtung nach einem der vorangehenden Ansprüche, dadurch gekennzeichnet, daß die senkrechten Kabelführungsteile einzeln abschließbare Kabelkanäle mit abnehmbaren, ggf. verschließbaren Türen (26) sind.

7. Geräte- und Kabeltrageeinrichtung nach einem der vorangehenden Ansprüche, dadurch gekennzeichnet, daß mindestens ein Kabelkanalteil auf der der Kabelzuführeinrichtung (20) gegenüberliegenden Seite, der Frontseite, mit einer aushängbaren Tür (26), bevorzugt abschließbar, versehen ist.

8. Geräte- und Kabeltrageeinrichtung nach Anspruch 6 oder 7, dadurch gekennzeichnet, daß mindestens einige der Türen schnell aushängbare Scharniere (27) aufweisen.

## Claims

1. Apparatus- and cable-carrying arrangement, characterised by end elements (10) and intermediate elements (12) which are securable to one another, the apparatus- and cable-carrying arrangement respectively comprising two end elements (10) and intermediate elements (12) which are to be disposed therebetween in any desirable quantity,
a) each intermediate element (12) comprising an upper cable duct portion (13) and a lower cable duct portion (14), as well as a vertical cable guiding member (16) which is respectively connectable centrally to the upper cable duct portion (13) and the lower cable duct portion (14), and respectively comprising a hollow cable feeding member (20) extending vertically from the lower cable duct portion to the upper cable duct portion, the cable feeding member (20) being placed over openings in the lower and upper cable duct portions so that it is possible to pass a cable through these cable portions;
b) each end element (10) comprising a lower cable duct end portion (17) and an upper cable duct end portion (18), as well as a cable guiding end portion (19) which is vertically securable on the ends of the cable duct end portions, the hollow cable guiding end portion (19) being placed over openings in the lower and upper cable duct end portions (17, 18) so that it is possible to pass electrical leads therethrough, as well as comprising lower and upper hollow, tubular cable feeding members (20), which extend vertically through the cable ducts and the cable guiding member and preferably have a rectangular tube-like configuration; and
c) horizontal frame portions (21) and vertical frame portions (22), preferably double frame portions, being provided, which extend between the upper and lower cable feeding members (20) parallel to the vertical cable guiding members and comprise securing means, such as bores.

2. Apparatus- and cable-carrying arrangement according to claim 1, characterised in that sheets (24) are additionally provided, which extend vertically between the upper and lower cable feeding members (20) and have securing means which communicate with the vertical frame portions.

3. Apparatus- and cable-carrying arrangement according to claim 1, characterised in that the frame portions (21, 22) are double frames provided with bores.

4. Apparatus and cable-carrying arrangement according to claim 2, characterised in that the sheets (24) are perforate sheets, the holes being securing means.

5. Apparatus and cable-carrying arrangement according to one of the preceding claims, characterised in that the spacings between the individual securing means and the epacing between the cable ducts are so selected that they correspond to the 19-inch ordnance (19-inch architecture of EDV technology).

6. Apparatus and cable-carrying arrangement according to one of the preceding claims, characterised in that the vertical cable guiding members are cable ducts which are individually closable and are provided with removable, possibly lockable doors (26).

7. Apparatus- and cable-carrying arrangement according to one of the preceding claims, characterized in that at least one cable duct portion is provided with a door (26), which can be taken off its hinges, is preferably closable, on the side situated opposite the cable feeding member (20), the front side.

8. Apparatus- and cable-carrying arrangement according to claim 6 or 7, characterised in that at least some of the doors have rapidly removable hinges (27).

## Revendications

1. Dispositif de support de matériels et de câbles, caractérisé par des éléments d'extrémité (10) et des éléments intermédiaires (12), qui peuvent être fixés les uns aux autres, ledit dispositif de support de matériels et de câbles comportant respectivement deux éléments d'extrémité (10) entre lesquels peuvent être agencés des éléments intermédiaires (12) en nombre quelconque, dispositif dans lequel :
a) chaque élément intermédiaire (12) comprend une partie de conduite de câble supérieure (13) et une partie de conduite de câble inférieure (14) ainsi qu'une partie de guidage de câble verticale (16), qui peut être raccordée, respectivement au centre, à la partie de conduite de câble supérieure (13) et à la partie de conduite de câble inférieure (14), et comporte respectivement une partie d'amenée de câble creuse (20) s'étendant perpendiculairement de la partie de conduite de câble inférieure à la partie de conduite de câble supérieure, ladite partie d'amenée de câble (20) étant placée sur des ouvertures des parties de conduite de câble inférieure et supérieure de telle sorte que le passage d'un câble à travers ces parties de conduite soit possible,
b) chaque élément d'extrémité (10) comprend une partie d'extrémité de conduite de câble inférieure (17) et une partie d'extrémité de conduite de câble supérieure (18) ainsi qu'une partie d'extrémité de guidage de câble (19) qui peut être fixée perpendiculairement sur les extrémités des parties d'extrémité de conduite de câble, la partie d'extrémité de guidage de câble creuse (19) étant placée sur des ouvertures des parties d'extrémité de conduite de câble supérieure et inférieure (17, 18) de telle sorte qu'un passage de lignes électriques à travers celles-ci soit possible, ainsi que des parties d'amenée de câble creuses (20) inférieure et supérieure, en forme de tube, de préférence de tube à section carrée, s'étendant perpendiculairement desdites parties d'extrémité à travers les conduites de câble et la partie de guidage de câble, et
c) il est prévu des parties de bâti horizontale (21) et verticale (22), de préférence des parties de bâti doubles, qui s'étendent entre les parties d'amenée de câble supérieure et inférieure (20), parallèlement aux parties de guidage de câble verticales, et comportent des dispositifs de fixation, tels que des alésages.

2. Dispositif de support de matériels et de câbles selon la revendication 1, caractérisé en ce qu'il est prévu en outre, entre les parties d'amenée de câble supérieure et inférieure (20), des tales (24) s'étendant verticalement et pourvues de dispositifs de fixation, lesdites tôles se raccordant aux parties de bâti verticales.

3. Dispositif de support de matériels et de câbles selon la revendication 1, caractérisé en ce que les parties de bâti (21, 22) sont des bâtis doubles pourvus d'alésages.

4. Dispositif de support de matériels et de câbles selon la revendication 2, caractérisé en ce que les tôles (24) sont des tôles perforées dont les trous constituent des dispositifs de fixation.

5. Dispositif de support de matériels et de câbles selon l'une quelconque des revendications précédentes, caractérisé en ce que les distances entre les dispositifs de fixation individuels et la distance entre les conduites de câble sont choisies de manière à correspondre à un agencement de 19 pouces (architecture de 19 pouces en technique EDV).

6. Dispositif de support de matériels et de câbles selon l'une quelconque des revendications précédentes, caractérisé en ce que les parties de guidage de câble verticales sont des conduites de câble qui peuvent être individuellement fermées par des portes (26) retirables, éventuellement verrouillables.

7. Dispositif de support de matériels et de câbles selon l'une quelconque des revendications précédentes, caractérisé en ce qu'au moins une partie de conduite de câble est pourvue, sur le côté en regard du dispositif d'amenée de câble (20), le côté frontal, d'une porte (26) qui peut être enlevée de ses gonds, de préférence qui est susceptible d'être fermée.

8. Dispositif de support de matériels et de câbles selon la revendication 6 ou 7, caractérisé en ce qu'au moins certaines des portes comportent des charnières (27) démontables rapidement.
